# EUROPEAN PATENT APPLICATION

(11) **EP 3 662 776 A1**
(43) Date of publication of application: **10.06.2020**
(21) Application number: 18841183.9
(22) Date of filing: 01.08.2018
(51) Int. Cl.: A43B 3/00

(54) **POWER GENERATION DEVICE FOR FOOTWEAR PRODUCT, AND OPERATION METHOD THEREOF**

(30) Priority: 01.08.2017 CN 201710645742
(71) Applicant: Qingyuan Global Technology Services Ltd., Qingyuan City, Guangdong 511800 (CN)
(72) Inventor: LUH, Yih- Ping, Taipei City 104 (TW)
(74) Representative: dompatent von Kreisler Selting Werner - Partnerschaft von Patent- und Rechtsanwälten mbB
(86) International application number: PCT/CN2018/097896
(87) International publication number: WO 2019/024856

(57) **Abstract**

An electricity generating apparatus applied to footwear and an operating method thereof are disclosed. The electricity generating apparatus includes a stress plate, an electricity generating module and a charging circuit. The stress plate is disposed in footwear to bear a stress. The electricity generating apparatus generates magnetic field changes under the stress and induces the magnetic field changes to generate electricity. The charging circuit is coupled to the footwear and used to receive the electricity and selectively provide the electricity to the footwear.

## Description

### BACKGROUND OF THE INVENTION

### 1. Field of the invention

The invention relates to footwear; in particular, to an electricity generating apparatus applied to footwear and an operating method thereof.

### 2. Description of the prior art

Many different styles of light-emitting shoes have appeared on the market. The light-emitting effect is achieved by light-emitting diodes (LEDs) arranged on different parts of the shoes.

However, ordinary light-emitting shoes usually need to be charged through a universal serial bus (USB) to provide the power required for LEDs to emit lights. That is to say, the current light-emitting shoes still need to charge the rechargeable battery of the light-emitting shoes through external power to make the light-emitting shoes shine. Once the power stored in the rechargeable battery of the light-emitting shoes is exhausted, if the user cannot charge the light-emitting shoes through the USB immediately, the light-emitting shoes cannot continue to maintain the light-emitting effect.

### SUMMARY OF THE INVENTION

Therefore, the invention provides an electricity generating apparatus applied to footwear and an operating method thereof to solve the above-mentioned problems of the prior arts.

A preferred embodiment of the invention is an electricity generating apparatus applied to a footwear. In this embodiment, the electricity generating apparatus includes a stress plate, an electricity generating module and a charging circuit. The stress plate is disposed in the footwear to bear a stress. The electricity generating module is configured to generate magnetic field changes under the stress and induce the magnetic field changes to generate an electricity. The charging circuit is coupled to the footwear and configured to receive the electricity and selectively provide the electricity to the footwear.

In an embodiment, the footwear comprises at least one light-emitting unit coupled to the charging circuit, and the charging circuit selectively provides the electricity to the at least one light-emitting unit, so that the at least one light-emitting unit emits lights.

In an embodiment, the electricity provided by the charging circuit to the at least one light-emitting unit has a pulse type, so that the at least one light-emitting unit emits a flash.

In an embodiment, the at least one light-emitting unit further has a fluorescent object configured to turn the flash emitted by the at least one light-emitting unit into a continuous light.

In an embodiment, the charging circuit comprises a capacitor and a switch; the switch is disposed between the capacitor and the footwear; the electricity received by the charging circuit is stored in the capacitor, and the switch controls whether the electricity stored in the capacitor is provided to the footwear or not.

In an embodiment, the electricity generating module further includes a magnet unit and an induction coil. The magnet unit is configured to generate the magnetic field changes due to the stress. The induction coil is arranged adjacent to the magnet unit and configured to sense the magnetic field change to generate the electricity.

Another embodiment of the invention is an electricity generating apparatus operating method. In an embodiment, the electricity generating apparatus operating method is used for operating an electricity generating apparatus applied to a footwear. The electricity generating apparatus includes a stress plate, an electricity generating module and a charging circuit. The stress plate is disposed in the footwear. The electricity generating apparatus operating method includes steps of: when the stress plate bears a stress, the electricity generating module generating magnetic field changes under the stress and inducing the magnetic field changes to generate an electricity; and the charging circuit receiving the electricity and selectively providing the electricity to the footwear.

Compared to the prior art, in the electricity generating apparatus and the operation method thereof applied to the footwear of the invention, the magnetoelectric mechanism of the footwear is driven by the foot stress when the user is walking in footwear to induce to generate electricity and the electricity is stored in the charging capacitor and provided to the light-emitting units (e.g., the LEDs) on the footwear to emit lights. Therefore, when the light-emitting shoes fail to emit lights without electricity, the user does not need to provide electricity to the light-emitting shoes through the external charging way. The user only needs to continue walking and apply the foot stress to keep the light-emitting shoes continue to emit lights, not only convenient for users, but also save the cost of external charging.

The advantage and spirit of the invention may be understood by the following detailed descriptions together with the appended drawings.

### BRIEF DESCRIPTION OF THE APPENDED DRAWINGS

FIG. 1 illustrates a schematic diagram of the light-emitting units 12 disposed on the footwear 1.
FIG. 2 illustrates a functional block diagram of the electricity generating apparatus 10 applied to the footwear 1 in a preferred embodiment of the invention.
FIG. 3 illustrates a schematic diagram of the electricity generating module 102 including a magnet unit MA and an induction coil CO.
FIG. 4 illustrates an embodiment of the charging circuit 104.
FIG. 5 illustrates a flowchart of the electricity generating apparatus operating method in another embodiment of the invention.

### DETAILED DESCRIPTION OF THE INVENTION

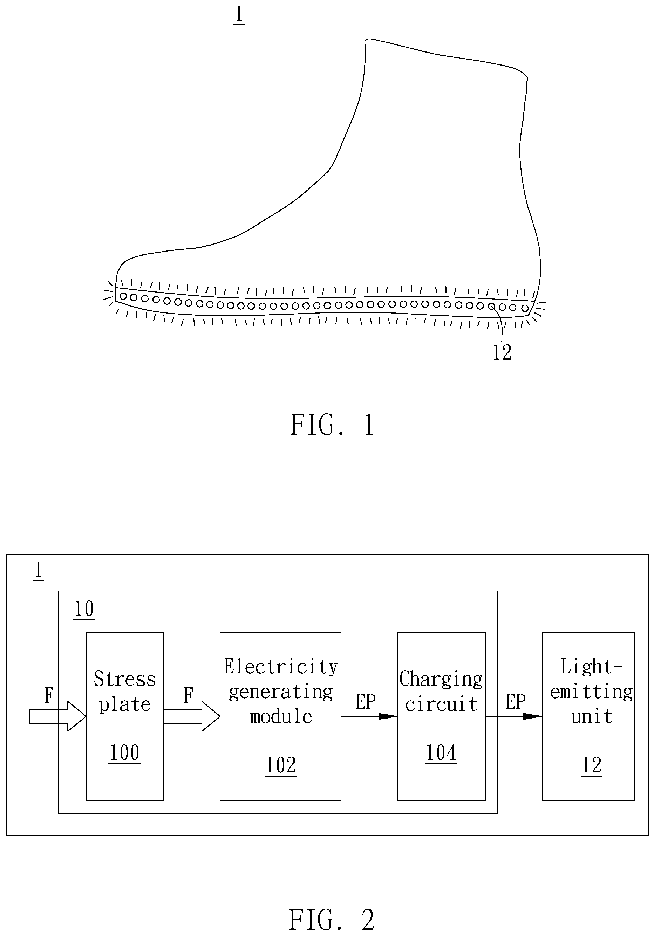

An embodiment of the invention is an electricity generating apparatus applied to the footwear. In this embodiment, the electricity generating apparatus can be applied to a light-emitting shoe and the light-emitting shoe includes at least one light-emitting unit, such as a light-emitting diode (LED), and the at least one light-emitting unit can be disposed at different places such as the sole or the body of the light-emitting shoe. For example, the light-emitting units 12 in FIG. 1 are disposed on a side of the sole of the footwear 1 to emit lights, but not limited to this.

It should be noted that the electricity generating apparatus disposed in the footwear 1 drives the magnetoelectric mechanism of the footwear 1 by the foot stress when the user is walking in the footwear 1 to induce to generate electricity and the electricity is stored in the capacitor and provided to the light-emitting units 12 (e.g., the LEDs) disposed on the footwear 1 to emit lights without external charging.

Please refer to FIG. 2. FIG. 2 is a functional block diagram of the electricity generating apparatus 10 applied to the footwear 1 in this embodiment. As shown in FIG. 2, the electricity generating apparatus 10 is disposed in the footwear 1 and the footwear 1 further includes at least one light-emitting unit 12. The electricity generating apparatus 10 includes a stress plate 100, an electricity generating module 102 and a charging circuit 104. The electricity generating module 102 is coupled to the charging circuit 104; the charging circuit 104 is coupled to the light-emitting unit 12.

In this embodiment, the stress plate 100 is disposed in the footwear 1 to bear a stress F. In practical applications, the stress plate 100 can be evenly arranged on the insole in the footwear 1 so as to uniformly bear the foot stress exerted on the insole by the user's feet when wearing the footwear 1, but not limited to this.

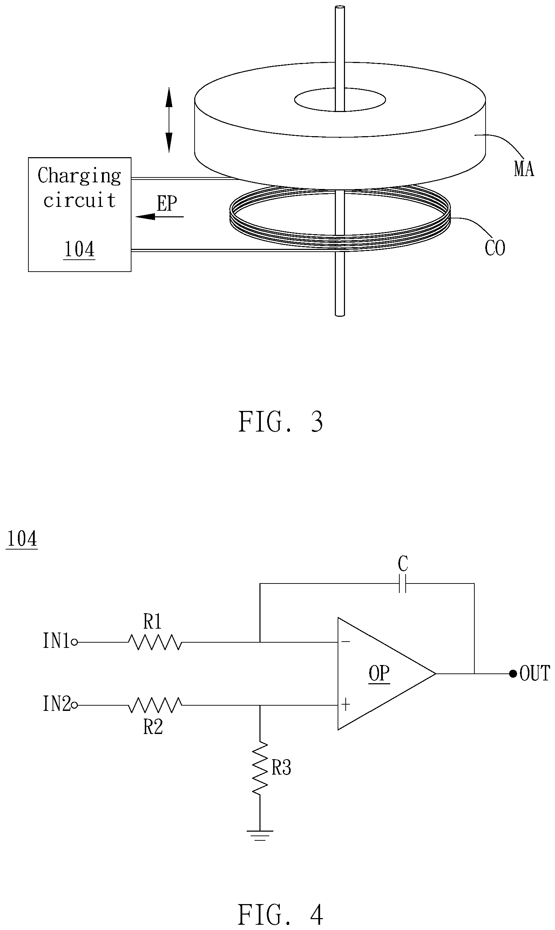

In this embodiment, the electricity generating module 102 is used to generate a magnetic field change under the effect of the stress F, and induce the magnetic field change to generate the electricity EP. For example, as shown in FIG. 3, the electricity generating module 102 can include a magnet unit MA and an induction coil CO. The magnet unit MA and the induction coil CO are arranged adjacent to each other. When the electricity generating module 102 is subjected to the stress F, the magnet unit MA is subjected to the stress F to generate a change of the magnetic field (the magnetic field lines), and the induction coil CO will generate the electricity EP according to the change of the magnetic field (the magnetic field lines), and output it to the charging circuit 104 as a type of the induced voltage.

It should be noted that when the electricity generating module 102 is subjected to the stress F, the stress F can be applied to a gear set (not shown) to rotate, and the magnet unit MA is driven to change its state to generate the changes of the magnetic field (the magnetic field lines) by the rotation of the gear set, but not limited to this.

In this embodiment, the charging circuit 104 is configured to receive the electricity EP outputted from the electricity generating module 102 and selectively provide the electricity EP to the light-emitting unit 12 disposed on the footwear 1. Please refer to FIG. 4. FIG. 4 illustrates an embodiment of the charging circuit 104.

As shown in FIG. 4. The charging circuit 104 includes a first input terminal IN1, a second input terminal IN2, a first resistor R1, a second resistor R2, a third resistor R3, a capacitor C, an operational amplifier OP and an output terminal OUT. The first input terminal IN1 and the second input terminal IN2 are coupled to the electricity generating module 102; the first resistor R1 is coupled between the first input terminal IN1 and the negative input terminal - of the operational amplifier OP; the second resistor R2 is coupled between the second input terminal IN2 and the positive input terminal + of the operational amplifier OP; one terminal of the third resistor R3 is coupled between the second resistor R2 and the positive input terminal + of the operational amplifier OP and the other terminal of the third resistor R3 is grounded; one terminal of the capacitor C is coupled between the first resistor R1 and the negative input terminal - of the operational amplifier OP and the other terminal of the capacitor C is coupled between the operational amplifier OP and the output terminal OUT; the output terminal OUT is coupled to the light-emitting unit 12.

When the electricity EP generated by the electricity generating module 102 is outputted to the charging circuit 104 as a type of the induced voltage, the voltage difference between the first input terminal IN1 and the second input terminal IN2 of the charging circuit 104 is the induced voltage of the electricity EP. And, the charging circuit 104 generates an induced current to the capacitor C according to the induced voltage, so that the electricity EP is stored in the capacitor C, so as to selectively provide the electricity EP to the light-emitting unit 12 according to practical needs.

In practical applications, the charging circuit 104 can further include a switch (not shown) and set the switch between the capacitor C and the output terminal OUT, or a switch is disposed between the charging circuit 104 and the light-emitting unit 12 and used to control whether the power EP stored in the capacitor C is to be outputted to the light-emitting unit 12 through the switch. As for the type of the switch, there are no specific restrictions, and it can be various circuit switches, such as a transistor or a silicon-controlled rectifier (SCR).

It should be noted that if the power EP provided by the charging circuit 104 to the light-emitting unit 12 has a pulse type, the light-emitting unit 12 will emit a pulse-type light, that is, a flash, according to the pulse-type electricity EP. In addition, the light-emitting unit 12 can further be provided with a fluorescent object (such as a light-storing type fluorescent film, a fluorescent glue, or a fluorescent filament) for converting the flash light emitted by the light-emitting unit 12 into the continuous light.

Another embodiment of the invention is an electricity generating apparatus operating method. In this embodiment, the electricity generating apparatus operating method is used to operate an electricity generating apparatus. The electricity generating apparatus is applied to a footwear. The electricity generating apparatus includes a stress plate, an electricity generating module and a charging circuit. The stress plate is disposed in the footwear.

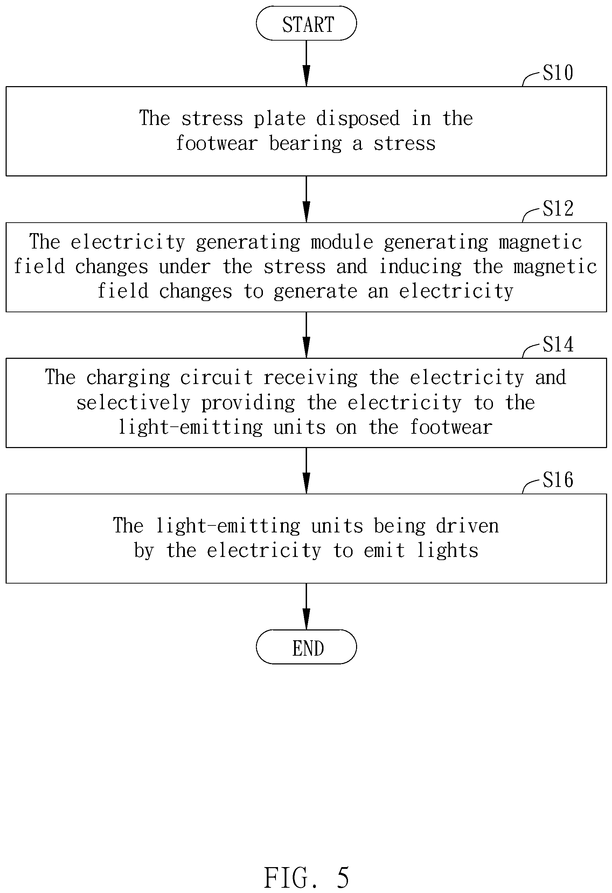

Please refer to FIG. 5. FIG. 5 illustrates a flowchart illustrating an electricity generating apparatus operation method of the invention. As shown in FIG. 5, the electricity generating apparatus operation method can include the following steps:
Step S10: the stress plate disposed in the footwear bearing a stress;
Step S12: the electricity generating module generating magnetic field changes under the stress and inducing the magnetic field changes to generate an electricity;
Step S14: the charging circuit receiving the electricity and selectively providing the electricity to the light-emitting units on the footwear; and
Step S16: the light-emitting unit is driven by the electricity to emit lights.

Compared to the prior art, in the electricity generating apparatus and the operation method thereof applied to the footwear of the invention, the magnetoelectric mechanism of the footwear is driven by the foot stress when the user is walking in footwear to induce to generate electricity and the electricity is stored in the charging capacitor and provided to the light-emitting units (e.g., the LEDs) on the footwear to emit lights. Therefore, when the light-emitting shoes fail to emit lights without electricity, the user does not need to provide electricity to the light-emitting shoes through the external charging way. The user only needs to continue walking and apply the foot stress to keep the light-emitting shoes continue to emit lights, not only convenient for users, but also save the cost of external charging.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. An electricity generating apparatus applied to a footwear, the electricity generating apparatus comprising:
a stress plate, disposed in the footwear to bear a stress;
an electricity generating module, configured to generate magnetic field changes under the stress and induce the magnetic field changes to generate an electricity; and
a charging circuit, coupled to the footwear and configured to receive the electricity and selectively provide the electricity to the footwear.

2. The electricity generating apparatus of claim 1, wherein the footwear comprises at least one light-emitting unit coupled to the charging circuit, and the charging circuit selectively provides the electricity to the at least one light-emitting unit, so that the at least one light-emitting unit emits lights.

3. The electricity generating apparatus of claim 2, wherein the electricity provided by the charging circuit to the at least one light-emitting unit has a pulse type, so that the at least one light-emitting unit emits a flash.

4. The electricity generating apparatus of claim 3, wherein the at least one light-emitting unit further has a fluorescent object configured to turn the flash emitted by the at least one light-emitting unit into a continuous light.

5. The electricity generating apparatus of claim 1, wherein the charging circuit comprises a capacitor and a switch; the switch is disposed between the capacitor and the footwear; the electricity received by the charging circuit is stored in the capacitor, and the switch controls whether the electricity stored in the capacitor is provided to the footwear or not.

6. The electricity generating apparatus of claim 1, wherein the electricity generating module further comprises:
a magnet unit, configured to generate the magnetic field changes due to the stress; and
an induction coil, arranged adjacent to the magnet unit and configured to sense the magnetic field change to generate the electricity.

7. An electricity generating apparatus operating method, for operating an electricity generating apparatus applied to a footwear, the electricity generating apparatus comprising a stress plate, an electricity generating module and a charging circuit, the stress plate being disposed in the footwear, the electricity generating apparatus operating method comprising steps of:
when the stress plate bears a stress, the electricity generating module generating magnetic field changes under the stress and inducing the magnetic field changes to generate an electricity; and
the charging circuit receiving the electricity and selectively providing the electricity to the footwear.

8. The electricity generating apparatus operating method of claim 7, wherein the footwear comprises at least one light-emitting unit coupled to the charging circuit, and the charging circuit selectively provides the electricity to the at least one light-emitting unit, so that the at least one light-emitting unit emits lights.

9. The electricity generating apparatus operating method of claim 8, wherein the electricity provided by the charging circuit to the at least one light-emitting unit has a pulse type, so that the at least one light-emitting unit emits a flash.

10. The electricity generating apparatus operating method of claim 9, wherein the at least one light-emitting unit further has a fluorescent object configured to turn the flash emitted by the at least one light-emitting unit into a continuous light.

11. The electricity generating apparatus operating method of claim 7, wherein the charging circuit comprises a capacitor and a switch; the switch is disposed between the capacitor and the footwear; the electricity received by the charging circuit is stored in the capacitor, and the switch controls whether the electricity stored in the capacitor is provided to the footwear or not.

12. The electricity generating apparatus operating method of claim 7, wherein the electricity generating module further comprises a magnet unit and an induction coil arranged adjacent to each other, when the magnet unit generates the magnetic field changes due to the stress, the induction coil senses the magnetic field change to generate the electricity.
